# EUROPÄISCHE PATENTSCHRIFT

(11) **EP 0 691 544 B1**
(45) Veröffentlichungstag und Bekanntmachung des Hinweises auf die Patenterteilung: **01.09.2004**
(21) Anmeldenummer: 95109485.3
(22) Anmeldetag: 20.06.1995
(51) Int. Cl.: G01R 15/18

(54) **Nach dem Kompensationsprinzip arbeitender Stromsensor**
Current sensor using the compensation principle
Capteur de courant utilisant le principe de compensation

(30) Priorität: 05.07.1994 DE 4423429
(43) Veröffentlichungstag der Anmeldung: 10.01.1996
(73) Patentinhaber: Vacuumschmelze GmbH, 63450 Hanau (DE)
(72) Erfinder: Lenhard, Friedrich, Dipl.-Ing., D-63452 Hanau (DE)
(74) Vertreter: Patentanwälte Westphal, Mussgnug & Partner

(56) Entgegenhaltungen:
- WO-A-94/23305
- FR-A- 2 692 991
- US-A- 3 323 057

## Beschreibung

Die Erfindung betrifft einen nach dem Kompensationsprinzip arbeitenden Stromsensor, insbesondere zur Messung von Gleich- und Wechselströmen, bei dem das in einem Magnetkern von einer vom zu messenden Strom durchflossenen Primärwicklung erzeugte Magnetfeld durch den Kompensationsstrom in einer Sekundärwicklung kompensiert wird, wobei zur Steuerung des Kompensationsstroms mindestens ein vom Magnetfeld beeinflußter Sensor Abweichungen vom Nullfluß erfaßt und diesen Meßwert über eine Auswerteschaltung einer Verstärkeranordnung zur Erzeugung des Kompensationsstromes zuführt, wobei die Sekundärwicklung und ein Abschlußwiderstand mit der Verstärkeranordnung so verbunden sind, daß am Abschlußwiderstand eine dem zu messenden Strom proportionale Spannung anliegt.

Derartige Stromsensoren sind beispielsweise aus der WO-A-9 423 305 und der US-A-3 323 057 bekannt.

Ein Stromsensor nach dem Kompensationsprinzip ist auch aus EP 356 248 bekannt. Das Schaltungsprinzip dieses bekannten Stromsensors ist in Fig. 1 dargestellt. Der zu messende Strom i1 fließt durch die Primärwicklung 1 eines Stromtransformators, der einen Magnetkern 2 besitzt sowie einen den Magnetfluß im Magnetkern 2 messenden Sensor 3.

In EP 356 248 besteht der Sensor 3 aus einem in die Sättigung gesteuerten Transformator mit rechteckförmiger Magnetisierungskennlinie. Im Prinzip kann aber jeder beliebige Sensor für ein Magnetfeld verwendet werden, z. B. Hallsonde, amorpher Streifen mit Wicklung usw.. Die Ausgangsspannung des Sensors 3 wird in einer nachgeschalteten Auswerteschaltung 4 ausgewertet, deren Ausgang an den Eingang einer Verstärkeranordnung 5 geschaltet ist. Der Ausgang der Verstärkeranordnung 5 ist über die Sekundärwicklung 6 des Stromtransformators und einen Abschlußwiderstand 7 mit Erde verbunden.

Die Wirkungsweise dieser Anordnung ist folgende: Der zu messende Strom erzeugt über die Primärwicklung 1 einen Fluß im Magnetkern 2, der vom Sensor 3 erfaßt wird. Die dem Sensor 3 nachgeschaltete Auswerteschaltung liefert ein von der Größe und Richtung des Magnetfeldes im Magnetkern 2 abhängiges Signal an die Verstärkeranordnung 5, die einen Kompensationsstrom durch die Senkundärwicklung 6 treibt. Der Kompensationsstrom ist so gerichtet, daß sein Magnetfeld den Magnetfluß im Magnetkern 2 kompensiert. Der Strom in der Sekundärwicklung 6 wird vom Sensor 3 solange geändert, bis das Magnetfeld im Magnetkern 2 zu Null wird. Damit ist der Strom in der Sekundärwicklung 6 ein Maß für den Augenblickswert des zu messenden Stromes in der Primärwicklung 1, so daß sowohl Gleich- als auch Wechselströme erfaßt werden können. Dieser Strom fließt außerdem noch über einen Abschlußwiderstand 7, an dem die Ausgangsspannung Ua des Stromsensors abfällt, die dadurch in Größe und Phasenlage dem zu messenden Strom in der Primärwicklung 1 entspricht.

Da diese Ausgangsspannung Ua abhängig von der Stromrichtung des zu messenden Stromes sowohl positive als auch negative Werte annehmen muß, wird - abhängig von der Stromrichtung - entweder ein Strom von dem Pluspol + der Versorgungsspannung der Verstärkeranordnung 5 über die Sekundärwicklung 6 und den Abschlußwiderstand 7 fließen, oder - bei umgekehrter Stromrichtung in der Primärwicklung 1 - wird ein Strom von dem Minuspol - der Verstärkeranordnung 5 zugeführt.

Bei dieser Anordnung hängt die maximale Ausgangsspannung Ua von der Größe der Versorgungsspannung der Verstärkeranordnung 5 sowie von dem Widerstandswert des Abschlußwiderstandes 7 und dem Widerstandswert des ohmschen Innenwiderstandes der Sekundärwicklung 6 ab. Insbesondere, wenn relativ große Ströme gemessen werden sollen, muß die Sekundärwicklung 6 viele Windungen haben, so daß deren Innenwiderstand sich zwangsweise vergrößert. Da außerdem die Versorgungsspannung der Verstärkeranordnung 5 nicht beliebig gesteigert werden kann, hat man zur Messung sehr großer Ströme, wie sie beispielsweise in Stromkreisen von Elektroautomobilen auftreten, entweder die Wahl, den Innenwiderstand der Sekundärwicklung 6 dadurch zu vermindern, daß ein dickerer Draht verwendet wird mit dem Nachteil, daß der Stromtransformator mit der Primärwicklung 1 und der Sekundärwicklung 6 relativ groß wird, oder man muß den Abschlußwiderstand 7 verkleinern. Diese Maßnahme hat aber den Nachteil, daß sich die Verlustleistung, die zur Erzeugung des Kompensationsstromes in der Sekundärwicklung 6 erforderlich ist, erhöht.

Aufgabe der vorliegenden Erfindung ist es, einen derartigen Stromsensor nach dem Kompensationsprinzip so zu verbessern, daß man bei gleichem zu messenden Strom das Bauvolumen des Stromsensors vermindern kann bzw. daß bei sonst gleicher Auslegung ein höherer Kompensationsstrom ermöglicht wird, so daß bei gleichem Bauvolumen des Stromtransformators und bei gleicher Empfindlichkeit mindestens der doppelte Maximalstrom in der Primärwicklung 1 erfaßt und korrekt kompensiert werden kann.

Diese Aufgabe wird erfindungsgemäß durch einen Stromsensor mit den Merkmalen des Anspruchs 1 oder des Anspruchs 4 gelöst.

Vorteilhafte Weiterbildungen sowie spezielle Lösungen für den Aufbau der Verstärkeranordnung 5 sind in den Unteransprüchen beschrieben.
Fig. 2 zeigt eine Schaltung mit zwei Teilwicklungen und einem Invertierverstärker;
in Fig. 3 ist eine Anordnung dargestellt, bei der zur Erfassung des Magnetflusses im Magnetkern zwei Sensoren vorgesehen sind und
Fig. 4 zeigt eine Anordnung, bei der auch ein Massebezug des Ausgangsstroms erhalten bleibt.

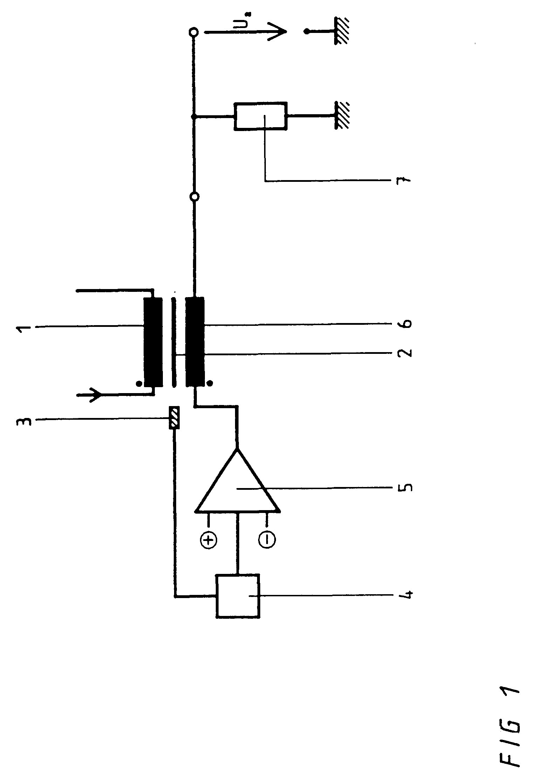

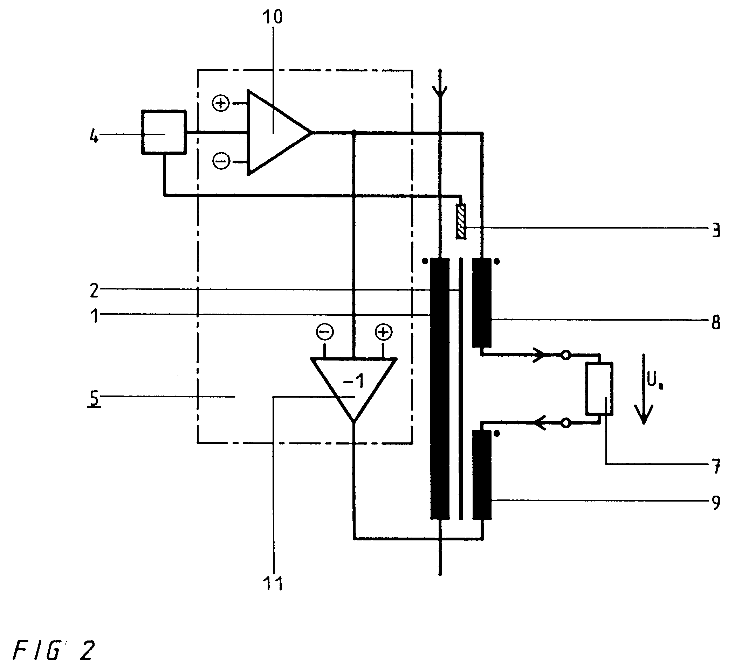

In den Fig. 2 bis 4 sind gleiche Teile wie in Fig. 1 mit den gleichen Bezugszeichen bezeichnet. Der zu messende Strom i1 fließt wiederum durch die Primärwicklung 1 eines Stromtransformators, der Magnetfluß des Magnetkerns 2 wird in einem Sensor 3 erfaßt und über eine Auswerteschaltung 4 einer Verstärkeranordnung 5 zugeführt.

Die in Fig. 1 mit 6 bezeichnete Sekundärwicklung ist hier aufgeteilt in zwei Teilwicklungen 8 und 9. Ein Wicklungsende der Teilwicklung 8 ist an den Ausgang eines Verstärkers 10 innerhalb der Verstärkeranordnung 5 angeschlossen. Das andere Wicklungsende ist über den Abschlußwiderstand 7 mit einem Wicklungsende der zweiten Teilwicklung 9 verbunden. Das zweite Wicklungsende der Teilwicklung 9 ist an den Ausgang eines Invertierverstärkers 11 in der Verstärkeranordnung 5 angeschlossen, dessen Eingang mit dem Ausgang des Verstärkers 10 verbunden ist. Bei gegebener Stromrichtung des zu messenden Stromes i1-fließt beispielsweise ein Strom von dem positiven Pol + der Versorgungsspannung des Verstärkers 10 über die Teilwicklung 8. Bei dieser Polarität des Ausgangs des Verstärkers 10 bewirkt der Invertierverstärker 11, daß eine Verbindung vom negativen Pol - der Versorgungsspannung zum Ausgang des Invertierverstärkers besteht. Damit fließt ein Strom vom positiven Pol des Verstärkers 10 über beide Teilwicklungen 8 und 9 sowie über den Abschlußwiderstand 7 zum negativen Pol der Versorgungsspannung - des Invertierverstärkers 11. Somit steht bei gleicher Größe der Versorgungsspannung gegenüber der bekannten Schaltung nach Fig. 1 die doppelte Spannung zur Erzeugung des Kompensationsstromes zur Verfügung, so daß entweder der doppelte maximale Strom gemessen werden kann oder bei gleicher Größe des Abschlußwiderstandes 7 die doppelte Ausgangsspannung Ua zur Verfügung steht.

Wenn sich die Richtung des zu messenden Stromes i1 umkehrt, wird entsprechend ein Stromfluß vom positiven Pol + der Versorgungsspannung über den Invertierverstärker 11, die Teilwickungen 8 und 9, den Abschlußwiderstand 7 zum negativen Pol - der Versorgungsspannung des Verstärkers 10 fließen. Im Gegensatz zur bekannten Anordnung nach Fig. 1 ist also - unabhängig von der Stromrichtung des zu messenden Stromes i1 immer eine symmetrische Belastung der Versorgungsspannung gegeben.

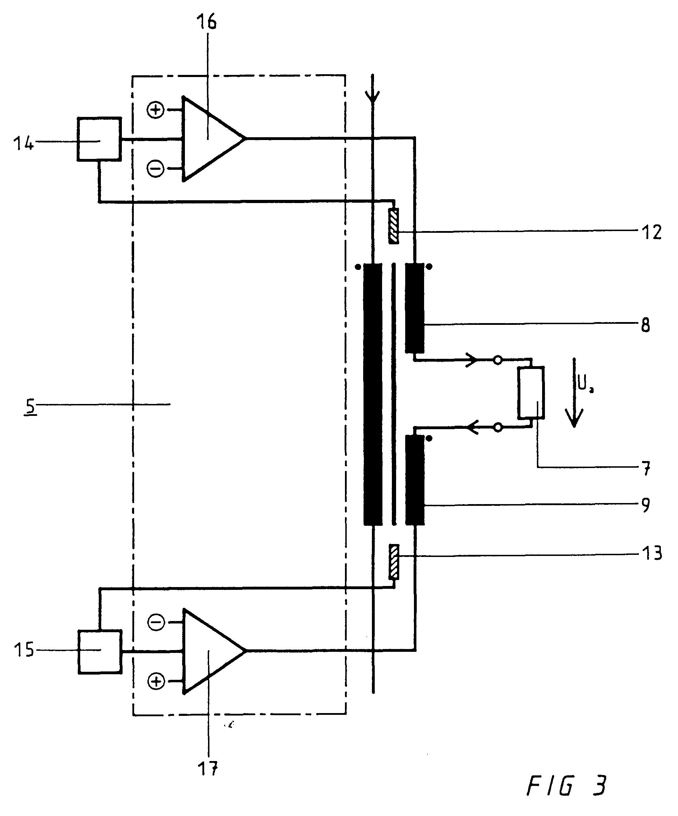

Die Anordnung nach Fig. 3 unterscheidet sich von dem Beispiel nach Fig. 2 dadurch, daß anstelle eines einzigen Sensors 3 zwei Sensoren 12 und 13 vorgesehen sind, die über je eine Auswerteschaltung 14 und 15 einen Verstärker 16 bzw. 17 innerhalb der Verstärkeranordnung 5 ansteuern. Auch hier kann die Schaltung wieder so getroffen werden, daß eine symmetrische Belastung der Versorgungsspannung vorliegt und damit ein doppelt so hoher maximaler Strom erfaßt werden bzw. das Bauvolumen des Stromsensors verringert werden kann.

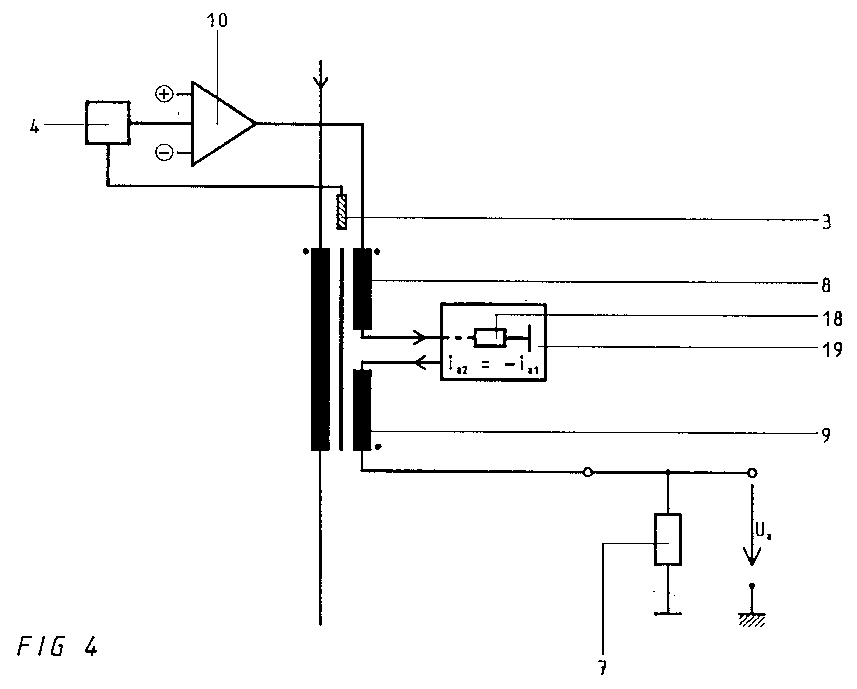

Fig. 4 zeigt eine Anordnung, die wiederum einen einzigen Sensor 3 mit Auswerteschaltung 4 und nachgeschaltetem Verstärker 10 hat, der eine Teilwicklung 8 speist. Die Teilwicklung 8 liegt hier in Reihe zu einem Meßwiderstand 18 innerhalb eines Stromkonverters 19. Der Spannungsabfall am Meßwiderstand 18 wird im Stromkonverter 19 ausgenutzt, um Größe und Richtung des Kompensationsstromes zu erfassen. Dieser Spannungsabfall ist damit geeignet, über einen oder mehrere weitere Verstärker weitere Teilwicklungen, z. B. die Teilwicklung 9 zu speisen. Nur eine dieser Teilwicklungen muß an den Abschlußwiderstand 7 für den Stromsensor angeschlossen sein, um eine dem zu messenden Strom i1 proportionale Ausgangsspannung Ua zu erzeugen. In diesem Fall ist die Ausgangsspannung Ua massebezogen.

Für den Fall, daß der Stromsensor Teil einer Regelungsschaltung ist, ist es selbstverständlich auch möglich, anstelle des Abschlußwiderstandes 7 den Innenwiderstand einer nachgeschalteten Regelungsstufe zu verwenden.

## Patentansprüche

1. Nach dem Kompensationsprinzip arbeitender Stromsensor, insbesondere zur Messung von Gleich- und Wechselströmen, bei dem das in einem Magnetkern (2) von einer vom zu messenden Strom durchflossenen Primärwicklung (1) erzeugte Magnetfeld durch den Kompensationsstrom in einer Sekundärwicklung (8, 9) kompensiert wird, wobei zur Steuerung des Kompensationsstromes mindestens ein vom Magnetfeld beeinflußter Sensor (3, 12) Abweichungen vom Nullfluß erfaßt und diesen Meßwert über eine Auswerteschaltung (4, 14) einer Verstärkeranordnung (5) zur Erzeugung des Kompensationsstromes zuführt, wobei die Sekundärwicklung (8, 9) und ein Abschlußwiderstand (7) mit der Verstärkeranordnung (5) so verbunden sind, daß am Abschlußwiderstand (7) eine dem zu messenden Strom proportionale Spannung (Ua) anliegt,
**dadurch gekennzeichnet, daß**
- die Sekundärwicklung eine erste Teilwicklung (8) und eine zweite Teilwicklung (9) aufweist, zwischen die der Abschlußwiderstand (7) geschaltet ist,
- die Verstärkeranordnung (5) einen ersten Verstärker (10, 16) und einen zweiten Verstärker (11, 17) aufweist,
- bei der die erste Teilwicklung (8) mit dem Ausgang des ersten Verstärkers (10, 16), und die zweite Teilwicklung (9) mit dem Ausgang des zweiten Verstärkers (11, 17) verbunden ist,
- bei der die Verstärker (10, 11, 16, 17) derart ausgestaltet und geschaltet sind, daß am Ausgang des ersten Verstärkers (10, 16) eine positive Spannung liegt, wenn am Ausgang des zweiten Verstärkers (11, 17) eine negative Spannung anliegt.

2. Stromsensor nach Anspruch 1,
**dadurch gekennzeichnet, daß**
- der zweite Verstärker (11) als invertierender Verstärker ausgestaltet ist,
- der zweite Verstärker (11) eingangsseitig mit dem Ausgang des ersten Verstärkers (10) verbunden ist,
- der erste Verstärker (10) eingangsseitig mit der Auswerteschaltung (4) verbunden ist.

3. Stromsensor nach Anspruch 1,
**dadurch gekennzeichnet, daß**
- der erste Verstärker (16) eingangsseitig mit der Auswerteschaltung (14) verbunden ist,
- ein weiterer Sensor (13) vorgesehen ist, der Abweichungen vom Nullfeld erfaßt und mit einer weiteren Auswerteschaltung (15) verbunden ist,
- bei der der zweite Verstärker (17) eingangsseitig mit der weiteren Auswerteschaltung (15) verbunden ist.

4. Nach dem Kompensationsprinzip arbeitender Stromsensor, insbesondere zur Messung von Gleich- und Wechselströmen, bei dem das in einem Magnetkern (2) von einer vom zu messenden Strom durchflossenen Primärwicklung (1) erzeugte Magnetfeld durch den Kompensationsstrom in einer Sekundärwicklung (8, 9) kompensiert wird, wobei zur Steuerung des Kompensationsstromes mindestens ein vom Magnetfeld beeinflußter Sensor (3) Abweichungen vom Nullfluß erfaßt und diesen Meßwert über eine Auswerteschaltung (4) einer Verstärkeranordnung zur Erzeugung des Kompensationsstromes zuführt, wobei die Sekundärwicklung (8, 9) und ein Abschlußwiderstand (7) mit der Verstärkeranordnung so verbunden sind, daß am Abschlußwiderstand (7) eine dem zu messenden Strom proportionale Spannung (Ua) anliegt, **dadurch gekennzeichnet, daß**
- die Sekundärwicklung mindestens eine erste Teilwicklung (8), die in Reihe zu einem Meßwiderstand (18) geschaltet ist, und eine zweite Teilwicklung (9), die in Reihe zum Abschlußwiderstand (7) geschaltet ist, aufweist,
- die Verstärkeranordnung einen ersten Verstärker (10), der eingangsseitig mit der Auswerteschaltung (4) und ausgangsseitig mit der ersten Teilwicklung (8) verbunden ist, und mindestens einen zweiten Verstärker aufweist, der als Verstärker mit invertiertem Ausgangsstrom ausgestaltet ist, ausgangsseitig mit der zweiten Teilwicklung (9) verbunden ist und derart mit dem Meßwiderstand (18) verbunden ist, daß ein Spannungsabfall am Meßwiderstand (18) als Eingangssignal für den zweiten Verstärker dient.

## Claims

1. Current sensor operating in accordance with the principle of compensation, in particular for measuring direct and alternating currents, in which the magnetic field generated in a magnetic core (2) by a primary winding (1) through which the current to be measured flows is compensated for by the compensating current in a secondary winding (6, 8, 9), in which, in order to control the compensating current, at least one sensor (3, 12) influenced by the magnetic field detects deviations from the null flux and supplies this measured value via an evaluation circuit (4, 14) to an amplifier arrangement (5) in order to generate the compensating current, and in which the secondary winding (8, 9) and a terminating resistor (7) are connected to the amplifier arrangement (5) in such a manner that a voltage (Ua) proportional to the current to be measured is applied to the terminating resistor (7), **characterised in that**
- the secondary winding has a first partial winding (8) and a second partial winding (9) between which the terminating resistor (7) is connected, and
- the amplifier arrangement (5) has a first amplifier (10, 16) and a second amplifier (11, 17),
- in which the first partial winding (8) is connected to the output of the first amplifier (10, 16) and the second partial winding (9) is connected to the output of the second amplifier (11, 17), and
- in which the amplifiers (10, 11, 16, 17) are designed and connected in such a manner that a positive voltage is applied to the output of the first amplifier (10, 16) when a negative voltage is applied to the output of the second amplifier (11, 17).

2. Current sensor according to claim 1, **characterised in that**
- the second amplifier (11) is designed as an inverting amplifier,
- the second amplifier (11) is connected at the input side to the output of the first amplifier (10), and
- the first amplifier (10) is connected at the input side to the evaluation circuit (4).

3. Current sensor according to claim 1, **characterised in that**
- the first amplifier (16) is connected at the input side to the evaluation circuit ( 14), and
- a further sensor (13) which detects deviations from the zero field and is connected to a further evaluation circuit (15) is provided,
- in which the second amplifier (17) is connected at the input side to the further evaluation circuit (15).

4. Current sensor operating in accordance with the principle of compensation, in particular for measuring direct and alternating currents, in which the magnetic field generated in a magnetic core (2) by a primary winding (1) through which the current to be measured flows is compensated for by the compensating current in a secondary winding (8, 9), in which, in order to control the compensating current, at least one sensor (3) influenced by the magnetic field detects deviations from the null flux and supplies this measured value via an evaluation circuit (4) to an amplifier arrangement in order to generate the compensating current, and in which the secondary winding (8, 9) and a terminating resistor (7) are connected to the amplifier arrangement in such a manner that a voltage (Ua) proportional to the current to be measured is applied to the terminating resistor (7), **characterised in that**
- the secondary winding has at least a first partial winding (8) connected in series with a measuring resistor (18) and a second partial winding (9) connected in series with the terminating resistor (7), and
- the amplifier arrangement has a first amplifier (10) connected at the input side to the evaluation circuit (4) and at the output side to the first partial winding (8), and at least a second amplifier designed as an amplifier with an inverted output current, connected at the output side to the second partial winding (9) and connected to the measuring resistor (18) in such a manner that a drop in voltage at the measuring resistor (18) serves as an input signal for the second amplifier.

## Revendications

1. Capteur de courant qui fonctionne selon le principe de compensation, destiné en particulier à mesurer des courants continus et des courants alternatifs, dans lequel le champ magnétique, produit dans un noyau magnétique (2) par un enroulement primaire (1) traversé par le courant à mesurer, est compensé par le courant de compensation dans un enroulement secondaire (6, 8, 9), avec pour commander le courant de compensation au moins un capteur (3, 12) influencé par le champ magnétique qui enregistre des écarts par rapport au flux nul et achemine cette valeur mesurée à un système d'amplificateurs (5) par l'intermédiaire d'un circuit d'exploitation (4, 14) afin de produire le courant de compensation, l'enroulement secondaire (8, 9) et une résistance de charge (7) étant liés au système d'amplificateurs (5) de telle manière que la résistance de charge (7) fournit une tension (Ua) proportionnelle au courant à mesurer,
**caractérisé en ce que**
- l'enroulement secondaire présente un premier enroulement partiel (8) et un deuxième enroulement partiel (9) entre lesquels est montée la résistance de charge (7),
- le système d'amplificateurs (5) présente un premier amplificateur (10, 16) et un deuxième amplificateur (11, 17),
- le premier enroulement partiel (8) est relié à la sortie du premier amplificateur (10, 16) et le deuxième enroulement partiel (9) à la sortie du deuxième amplificateur (11, 17), et
- les amplificateurs (10, 11, 16, 17) sont conçus et montés de telle manière qu'on a une tension positive à la sortie du premier amplificateur (10, 16) lorsqu'on a une tension négative à la sortie du deuxième amplificateur (11, 17).

2. Capteur de courant selon la revendication 1,
**caractérisé en ce que**
- le deuxième amplificateur (11) prend la forme d'un amplificateur inverseur,
- le deuxième amplificateur (11) est relié côté entrée à la sortie du premier amplificateur (10),
- le premier amplificateur (10) est relié côté entrée au circuit d'exploitation (4).

3. Capteur de courant selon la revendication 1,
**caractérisé en ce que**
- le premier amplificateur (16) est relié côté entrée au circuit d'exploitation (14),
- on prévoit un autre capteur (13) qui enregistre les écarts par rapport au champ nul et est relié à un autre circuit d'exploitation (15), et
- le deuxième amplificateur (17) côté entrée est relié à l'autre circuit d'exploitation (15).

4. Capteur de courant qui fonctionne selon le principe de compensation, destiné en particulier à mesurer des courants continus et des courants alternatifs, dans lequel le champ magnétique, produit dans un noyau magnétique (2) par un enroulement primaire (1) traversé par le courant à mesurer, est compensé par le courant de compensation dans un enroulement secondaire (8, 9), avec pour commander le courant de compensation au moins un capteur (3) influencé par le champ magnétique qui enregistre des écarts par rapport au flux nul et achemine cette valeur mesurée à un système d'amplificateurs par l'intermédiaire d'un circuit d'exploitation (4) afin de produire le courant de compensation, l'enroulement secondaire (8, 9) et une résistance de charge (7) étant liés au système d'amplificateurs de telle manière que la résistance de charge (7) fournit une tension proportionnelle au courant à mesurer,
**caractérisé en ce que**
- l'enroulement secondaire présente au moins un premier enroulement partiel (8) qui est monté en série avec une résistance série (18) et un deuxième enroulement partiel (9) qui est monté en série avec la résistance de charge (7),
- le système d'amplificateurs (5) présente un premier amplificateur (10) qui est relié côté entrée au circuit d'exploitation (4) et côté sortie au premier enroulement partiel (8) et au moins un deuxième amplificateur, conçu sous forme d'amplificateur avec un courant de sortie inversé, qui est relié côté sortie au deuxième enroulement partiel (9) et est relié à la résistance série (18) de telle manière qu'une chute de tension sur la résistance série (18) sert de signal d'entrée pour le deuxième amplificateur.
